# EUROPÄISCHE PATENTANMELDUNG

(11) **EP 1 638 182 A2**
(43) Veröffentlichungstag der Anmeldung: **22.03.2006**
(21) Anmeldenummer: 05077634.3
(22) Anmeldetag: 31.05.2000
(51) Int. Cl.: H02H 1/04, G01R 15/18

(54) **Verfahren zum Betrieb eines elektronischen Überstromauslösers eines Leistungsschalters**

(30) Priorität: 04.06.1999 DE 19927029
(62) Teilanmeldung aus: 00951197.3
(71) Anmelder: SIEMENS AKTIENGESELLSCHAFT, 80333 München (DE)
(72) Erfinder: Baumgaertl, Ulrich, 13599 Berlin (DE); Schiller, Manfred, 14169 Berlin (DE)

(57) **Zusammenfassung**

Bei Leistungsschaltern, die einen Stromwandler (6) mit einer eisenlosen Stromerfassungsspule (7) und eine der Stromerfassungsspule (7) nachgeschaltete Integrationsschaltung (8) aufweisen, kann es aufgrund der unvermeidbaren Zeitkonstante der Integrationsschaltung (8) zu einer fehlerhaften Auslösung kommen. Dies wird durch ein Verfahren vermieden, bei dem die Momentanwerte des Stromes in festgelegten periodischen Abständen (n, n+1, n+2) erfasst und gespeichert werden. Die gespeicherten Messwerte werden nach Polarität und Größe verglichen. Erweisen sich die gespeicherten Werte bei gleicher Polarität als monoton fallend, so wird angenommen, dass von dem Integrator (8) ein Gleichglied ausgeht und es wird im elektronischen Auslöser des Leistungsschalters ein Auslösesperrsignal gesetzt.

## Beschreibung

Die Erfindung betrifft ein Verfahren zum Betrieb eines elektronischen Überstromauslösers eines Leistungsschalters, der zur Versorgung des Überstromauslösers mit einem dem Strom durch den Leistungsschalter proportionalen Signal einen Stromwandler mit einer eisenlosen Stromerfassungsspule und einen der Stromerfassungsspule nachgeschalteten Integrationsschaltung aufweist.

Stromwandler mit einer eisenlosen Stromerfassungsspule werden eingesetzt, um einen sehr großen Strombereich mit möglichst geringem Fehler zu überwachen. Das Ausgangssignal einer solchen Stromerfassungsspule, die auch als Rogowskispule bekannt ist, wird in der Integrationsschaltung verarbeitet, um das auf dem Rogowski-Prinzip beruhende, der Stromänderung proportionale Signal in ein dem zu messenden Strom direkt proportionales Signal umzuwandeln. Derartige Stromwandler sind beispielsweise aus den Druckschriften US 5,815,391, DE 26 56 817 oder US 5,015,945 bekannt. Die Umwandlung bereitet an sich keine Schwierigkeiten, da im Prinzip als Integrationsschaltung eine R-C-Kombination ausreicht. Jedoch vermag eine solche Integrationsschaltung Änderungen des zu messenden Stromes nicht beliebig rasch zu folgen. Daher ist nicht auszuschließen, dass am Ausgang der Integrationsschaltung ein Signal erscheint, obwohl der zu messende Strom den Wert NULL angenommen hat.

Das beschriebene Verhalten der Integrationsschaltung kann im Betrieb des Leistungsschalters zu Schwierigkeiten führen, wenn bei nicht mehr fließendem Strom am Ausgang der Integrationsschaltung ein Signal solcher Höhe erscheint, dass die weitere Verarbeitung des Signals in dem Überstromauslöser zur Abgabe eines Auslösebefehles an den Leistungsschalter führt.

Ein gattungsgemäßes Verfahren zum Erfassen des Stromes in einem Leiter eines Wechselstrom-Energieübertragungsnetzes ist aus der Druckschrift DE 44 02 762 C1 bekannt. Um das am Ausgang der Integrationsschaltung erfasste Signal dahingehend zu bewerten, ob es auf einen primärseitigen im Leiter des Wechselstrom-Energieübertragungsnetzes fließenden Strom oder auf einen bei unterbrochenem Strom im Leiter von der Integrationsschaltung hervorgerufenen, abklingenden Gleichstromglied (Gleichglied) beruht, ist bei diesem bekannten Verfahren vorgesehen aus einer aktuellen ersten Messgröße und einer älteren zweiten Messgröße vier Messhilfsgrößen zu erzeugen. Mittels dieser vier Messhilfsgrößen werden ein Betragssignal und ein Winkelsignal erzeugt. Anschließend wird aus dem Betrags- und Winkelsignal ein Ausgangssignal erzeugt, wenn diese Signale vorgegebene Schwellwerte überschreiten.

Der Erfindung liegt die Aufgabe zugrunde, ein anderes Verfahren zum Verhindern von Fehlauslösungen aufgrund des Verhaltens der Integrationsschaltung anzugeben.

Es wäre denkbar, diese Aufgabe durch folgende Schritte des eingangs genannten Verfahrens zu lösen:
a) Messung des Momentanwertes des Signals des Stromwandlers in festgelegten periodischen Abständen,
b) Speicherung von wenigstens zwei aufeinander folgenden, im Schritt a) gewonnenen Messwerten,
c) Vergleich jedes der Messwerte mit den wenigstens zwei zuvor gespeicherten Messwerten, und
d) Abgabe eines Auslöse-Sperrsignals an den elektronischen Überstromauslöser, wenn alle Messwerte einer monoton fallenden Funktion entsprechen und die Differenz aufeinander folgender Messwerte wenigsten 10% beträgt.

Dabei empfiehlt es sich, den zeitlichen Abstand der Messwerte klein gegenüber der Zeitkonstanten der Integrationsschaltung zu bemessen, und zwar vorzugsweise auf 4,5ms bei einer Frequenz des zu messenden Stromes von 50Hz.

Für die praktische Durchführung des dargelegten Verfahrens erweist es sich als ausreichend, zum aufeinander folgenden Vergleich der Messwerte diese in einen dreizelligen Ringpuffer einzulesen.

Die Erfindung sieht als Lösung der gestellten Aufgabe ein Verfahren vor, bei dem der Auslöseschwellwert des Überstromauslösers für kurzzeitverzögerte Auslösung und Erdschlussauslösung um einen Sockelbetrag erhöht ist, der einem von der Integrationsschaltung bei einer Unterbrechung des Stromes abgegebenen Gleichglied entspricht und dass der Sockelbetrag entsprechend einer Abklingfunktion des Gleichgliedes veränderlich ist. - Die Ermittlung des Sockelbetrages basiert also zunächst auf der Annahme, dass das am Ausgang der Integrationsschaltung erfasste Signal ausschließlich auf dem von Integrationsschaltung bei der Unterbrechung des Stromes hervorgerufenen, dem unterbrochenen Strom entsprechenden, hardwaremäßig vorgegebenen Gleichglied beruht, dessen weiteres Abklingverhalten ebenfalls hardwaremäßig vorgegeben ist.

Die Erfindung wird im Folgenden anhand des in den Figuren veranschaulichten Ausführungsbeispieles näher erläutert.

Die Figur 1 stellt ein Prinzipschaltbild eines Leistungsschalters mit elektronischem Überstromauslöser und Rogowski-Stromwandler dar.

Die Figur 2 zeigt ein Diagramm, in welchem der Verlauf des Primärstromes, die Ausgangsgröße eines Stromwandlers sowie die Ausgangsgröße eines Integrators über der Zeit dargestellt sind.

Die Figur 3 zeigt ein Flussdiagramm, welches das Prinzip des Verfahrens nach der Erfindung veranschaulicht.

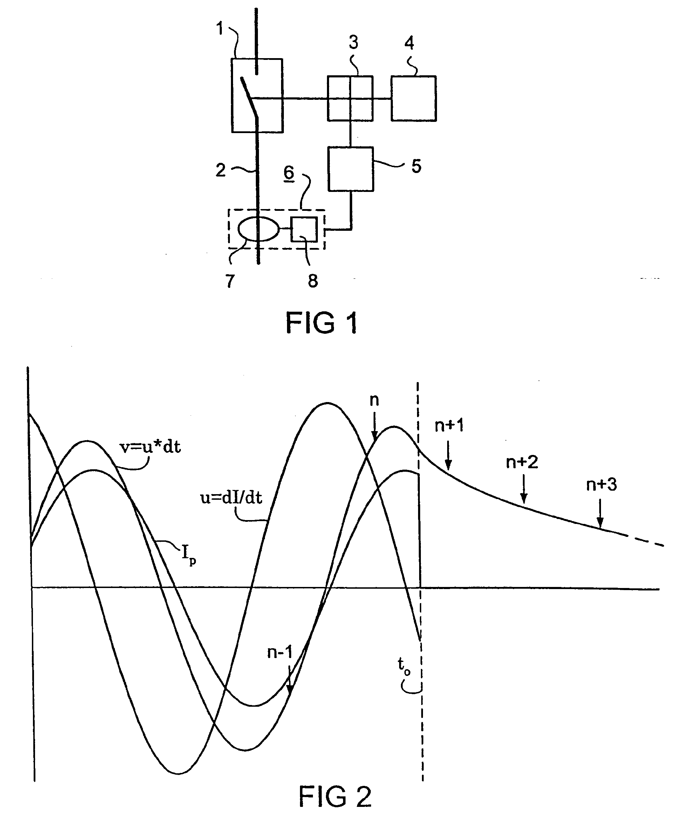

In der Figur 1 sind als Hauptkomponenten eines Niederspannungs-Leistungsschalters ein ein- oder mehrpoliger Schaltkontakt 1 in einer Hauptstrombahn 2, ein Schaltschloss 3 und eine Antriebsvorrichtung 4 gezeigt. Das in der Einschaltstellung des Schaltkontaktes 1 verklinkte Schaltschloss 3 ist durch einen elektronischen Überstromauslöser 5 lösbar, dem als Eingangsgröße ein dem Strom in der Hauptstrombahn 2 proportionales Steuersignal zugeführt wird. Dieses Steuersignal wird durch einen Stromwandler 6 bereitgestellt, der als eisenloser Wandler mit großem Dynamikbereich ausgebildet ist und neben einer Rogowski-Spule 7 eine Integrationsschaltung 8 enthält.

Der zeitliche Verlauf der Messgrößen ist näher aus der Figur 2 ersichtlich. In dieser ist mit Iₚ der tatsächliche Primärstrom in dem zu überwachenden Stromkreis bezeichnet. An der Rogowskispule des Stromwandlers ist eine Spannung u=dI/dt abzugreifen. Der der Rogowskispule nachgeschaltete Integrator (8 in Figur 1) formt diese Spannung in eine Größe v=udt um. Während der Strom I_{P} und die Spannung u zu dem mit t₀ bezeichneten Zeitpunkt der Stromunterbrechung enden, klingt die Spannung v am Ausgang des Integrators erst allmählich ab. Die Zeitpunkte, zu denen eine Momentanwerterfassung durchgeführt wird, sind entsprechend dem Flussdiagramm gemäß der Figur 1 mit n, n+1, n+2 und so fort bezeichnet. Besitzen diese Werte die gleiche Polarität und weisen eine fallende Tendenz auf, so ist klar, dass es sich ein von dem Integrator ausgehendes abklingendes Gleichglied handelt. In diesem Fall wird die Auslösung des Leistungsschalters unterdrückt und somit eine unnötige Störung in der Versorgung von Verbrauchern vermieden.

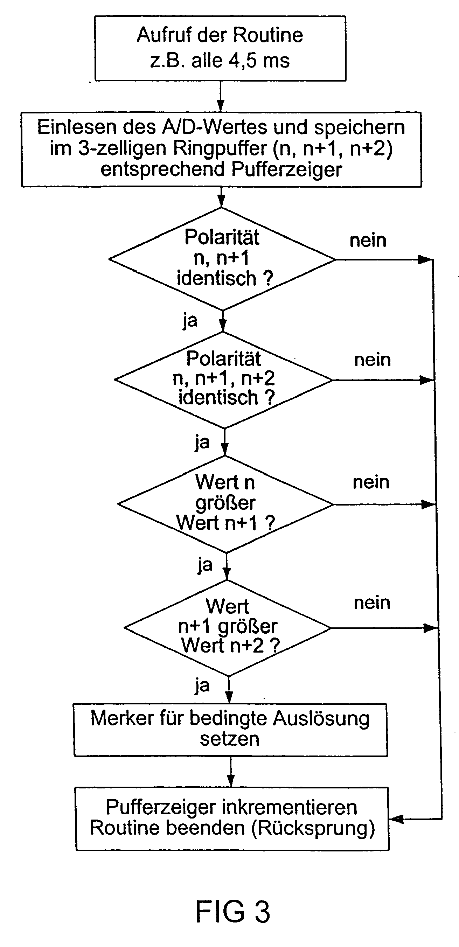

Das in der Figur 3 gezeigte Flussdiagramm beginnt mit dem periodischen Aufruf einer Prüfroutine, wobei sich die periodischen Abstände an der Abklingfunktion des Gleichgliedes der erwähnten Integrationsschaltung (8 in Figur 1) orientieren. Ein Abstand der Prüfroutinen von 4,5ms hat sich als angemessen erwiesen. In den genannten Abständen erfasste Messwerte werden in einem dreizelligen Ringpuffer mit den Positionen n, n+1 und n+2 eingelesen. Die in dem Ringpuffer gespeicherten aufeinander folgenden Werte werden nun nach Polarität und Wert miteinander verglichen. Weisen die aufeinander folgenden gespeicherten Werte die gleiche Polarität auf und nehmen sie wertmäßig zu, so sind die Voraussetzungen für eine bedingte Auslösung gegeben. Nehmen die Werte dagegen monoton ab, so deutete dies auf ein Gleichglied hin, das nicht zur Auslösung führen soll. Die Routine wird wiederholt, um die ordnungsgemäße Funktion des Leistungsschalters zu gewährleisten.

## Patentansprüche

1. Verfahren zum Betrieb eines elektronischen Überstromauslösers eines Leistungsschalters, der zur Versorgung des Überstromauslösers mit einem den Strom durch den Leistungsschalter proportionalen Signals einen Stromwandler mit einer eisenlosen Stromerfassungsspule und einen der Stromerfassungsspule nachgeschalteten Integrationsschaltung aufweist,
**dadurch gekennzeichnet,**
**dass** der Auslöseschwellwert des Überstromauslösers für kurzzeitverzögerte Auslösung und Erdschlussauslösung um einen Sockelbetrag erhöht ist, der einem von der Integrationsschaltung bei einer Unterbrechung des Stromes abgegebenen Gleichglied entspricht und dass der Sockelbetrag entsprechend einer Abklingfunktion des Gleichgliedes veränderlich ist.
